## Europäisches Patentamt
## European Patent Office
## Office européen des brevets

(11) Veröffentlichungsnummer: **0 406 456 A1**

# EUROPÄISCHE PATENTANMELDUNG

(21) Anmeldenummer: 89112105.5

(22) Anmeldetag: 03.07.89

(51) Int. Cl.⁵: **H01L 39/24**

(43) Veröffentlichungstag der Anmeldung:
09.01.91 Patentblatt 91/02

(84) Benannte Vertragsstaaten:
**AT CH DE FR GB IT LI NL SE**

(71) Anmelder: **Siemens Aktiengesellschaft**
**Wittelsbacherplatz 2**
**D-8000 München 2(DE)**

(72) Erfinder: **Assmann, Helmut, Dr. Dipl.-Phys.**
**Schwabachstrasse 13**
**D-8524 Dormitz(DE)**
Erfinder: **Günther, Andreas, Dipl.-Ing.**
**Geschwister-Scholl-Strasse 6**
**D-8520 Erlangen(DE)**

(54) Verfahren zum Herstellen eines hochtemperatursupraleitenden Bauteiles.

(57) Die Erfindung betrifft ein Verfahren zum Herstellen eines hochtemperatursupraleitenden Bauteiles. Dabei wird eine Schmelze gebildet, die Oxide, insbesondere Bi-Sr-Ca-Cu-Oxid oder Y-Ba-Cu-Oxid oder Seltene Erde-Ba-Cu-Oxid oder Tl-Sr-Ca-Cu-Oxid enthält. Die Schmelze wird, gegebenenfalls nach weiteren Verfahrensschritten, auf einen Trägerkörper aufgebracht. Es ist vorgesehen, daß der Schmelze, zum Verhindern einer Entmischung, ein Zusatzoxid mit einer Dietzelschen Feldstärke, die größer als 0,4 ist, zugemischt wird. Besonders geeignete Zusatzoxide sind beispielsweise $SiO_2$, $GeO_2$ oder $B_2O_3$.

EP 0 406 456 A1

## VERFAHREN ZUM HERSTELLEN EINES HOCHTEMPERATURSUPRALEITENDEN BAUTEILES

Die Erfindung betrifft ein Verfahren zum Herstellen eines hochtemperatursupraleitenden Bauteiles, wobei aus Oxiden, insbesondere aus Bi-Sr-Ca-Cu-Oxid oder Y-Ba-Cu-Oxid oder Seltene Erde-Ba-Cu-Oxid oder Tl-Sr-Ca-Cu-Oxid, eine Schmelze gebildet wird, welche anschließend auf einen Trägerkörper aufgebracht wird und dort bei einer Kristallisationstemperatur auskristallisiert wird.

Die Erfindung betrifft auch ein Verfahren zum Herstellen eines hochtemperatursupraleitenden Bauteiles, wobei aus Oxiden, insbesondere aus Bi-Sr-Ca-Cu-Oxid oder Y-Ba-Cu-Oxid oder Seltene Erde-Ba-Cu-Oxid oder Tl-Sr-Ca-Cu-Oxid eine Schmelze gebildet wird, die zu einem Glas erstarrt wird, das zu einer Fritte gemahlen wird, die dann als Glaskeramik-Email auf einen Trägerkörper aufgebracht wird.

Die Erfindung betrifft außerdem ein mit einem dieser Verfahren hergestelltes hochtemperatursupraleitendes Bauteil.

Die meisten Verfahren zum Herstellen eines hochtemperatursupraleitenden Bauteiles erfordern zunächst die Herstellung einer Schmelze aus Rohmaterial. Aus dieser Schmelze wird das hochtemperatursupraleitende Material gebildet. Beispielsweise wird ein hochtemperatursupraleitendes Bauteil durch Faserziehen aus der Schmelze hergestellt. Durch Eintauchen eines metallischen Substrats in die Schmelze kann eine hochtemperatursupraleitende Beschichtung erzeugt werden. Ein anderes Verfahren, das aus der europäischen Patentanmeldung 88121551.1 zu entnehmen ist, sieht vor, daß die Schmelze zu einem Glas abgeschreckt und dann pul verisiert wird. Auf diese Weise wird eine Fritte gebildet, die in einem Emaillierverfahren auf einen Trägerkörper aufgebracht wird.

Übliches Rohmaterial für keramische Hochtemperatursupraleiter, insbesondere Rohmaterial für eine hochtemperatursupraleitende Emailschicht, läßt sich besonders leicht schmelzen. Dieses Rohmaterial kann Bismutoxid, Erdalkalioxid oder Kupferoxid enthalten. Es können auch Zusätze, z.B. Bleioxid, Antimonoxid oder Yttriumoxid beigemischt sein.

Eine Schmelze, die zum Herstellen eines Hochtemperatursupraleiters geeignet ist, neigt im flüssigen Zustand zur Entmischung. Ähnlich wie bei Wasser und Öl bilden sich in der Schmelze Schichten mit unterschiedlicher Zusammensetzung aus. Die Schichten der Schmelze haben infolge der Entmischung dann nicht mehr die korrekte stoffliche Zusammensetzung, die für die Bildung eines hochtemperatursupraleitenden Stoffes erforderlich ist. Eine solche erfolgte Entmischung bleibt erhalten, auch wenn die Schmelze abgekühlt wird. Die unerwünschte Zusammensetzung behindert die Bildung eines hochtemperatursupraleitenden Stoffes.

Bedingt durch die Entmischung der Schmelze erhält man ein Bauteil mit variierender Leitfähigkeit. Hinzu kommt, daß aus der genannten Schmelze dort vorhandene, die Bildung eines hochtemperatursupraleitenden Stoffes störende Bestandteile der Schmelze vor denjenigen Bestandteilen, die die Bildung eines hochtemperatursupraleitenden Stoffes bewirken, auskristallisieren, so daß die Qualität des hochtemperatursupraleitenden Stoffes beeinträchtigt ist. Eine Beseitigung entmischter Bereiche und auch eine Beseitigung der zu früh auskristallisierten Bestandteile der Schmelze ist bisher nur mit langwierigen Verfahren, z.B. Langzeit-Glühverfahren, möglich.

Auch aus einem Glas, das eine erstarrte oder eingefrorene, unterkühlte Schmelze ist, kristallisieren störende Bestandteile bei einem erneuten Aufschmelzen frühzeitig aus und es kann dann zu einer Entmischung kommen. Ein frühzeitges Auskristallisieren und eine Entmischung treten insbesondere beim Emaillieren auf, wenn die aus dem Glas gebildete und auf den Trägerkörper aufgebrachte Fritte erwärmt wird.

Der Erfindung liegt die Aufgabe zugrunde, ein Verfahren zum Herstellen eines hochtemperatursupraleitenden Bauteiles anzugeben, bei dem eine Entmischung der Schmelze, die Oxide enthält, nicht auftritt und bei dem störende Bestandteile nicht vor denjenigen Bestandteilen auskristallisieren, die die Hochtemperatursupraleitung bewirken. Das Verfahren soll einsetzbar sein, falls die Schmelze direkt auf einen Trägerkörper aufgebracht wird und auch falls die Schmelze zu einer eingefrorenen Schmelze, einem Glas, erstarrt wird, das dann zu einer Fritte gemahlen wird, wobei die Fritte anschließend mit einem Emaillierverfahren auf einen Trägerkörper aufgebracht wird. Beim Emaillieren soll eine Entmischung in der Schmelze oder während des Aufschmelzens ausgeschlossen werden.

Es soll auch ein hochtemperatursupraleitendes Bauteil angegeben werden, das mit einem solchen Verfahren hergestellt ist.

Die erste Aufgabe wird gemäß der Erfindung dadurch gelöst, daß der Schmelze ein Zusatzoxid mit einer Dietzelschen Feldstärke, die größer als 0,4 ist, zugemischt wird.

Falls ein hochtemperatursupraleitendes Bauteil in einem Emaillierverfahren hergestellt werden soll, bei dem ein Entmischen der aufgeschmolzenen Fritte und Auskristallisieren störender Bestandteile aus der aufgeschmolzenen Fritte verhindert werden sollen, wird die erste Aufgabe gemäß der Erfindung dadurch gelöst, daß der erstarrten, gemahlenen Schmelze, der Fritte, ein Zusatzoxid mit einer Dietzelschen Feldstärke, die größer als 0,4 ist, in Pulverform zugemischt wird.

Die Dietzelsche Feldstärke ist nach Dietzel definiert als Quotient aus der Wertigkeit eines Kations durch den Abstand zwischen Kation und Anion zum Quadrat (siehe Dietzel; Emaillierung; Springer Verlag 1981; S. 50 ff.). Sie wird verwendet, um einschätzen zu können, in welchem Maße ein Oxid die Fähigkeit besitzt, ein amorphes Netzwerk zu bilden. Je höher die Dietzelsche Feldstärke eines Oxides ist, desto geringer ist dessen Neigung kristalline Phasen zu bilden und desto größer ist dessen Neigung ein glasiges Netzwerk zu bilden. Man unterscheidet im allgemeinen Netzwerkwandler mit einer Dietzelschen Feldstärke kleiner 0,4, die eine starke Neigung haben zu kristallisieren; Netzwerkbildner mit einer Dietzelschen Feldstärke größer 1,0, die eine geringe Neigung haben zu kristallisieren und Zwischenoxide mit einer Dietzelschen Feldstärke zwischen 0,4 und 1,0, die je nach den herrschenden Bedingungen sowohl als Netzwerkwandler als auch als Netzwerkbildner fungieren zu können.

Mit der Zumischung eines Zusatzoxides, das als Netzwerkbildner wirkt oder die Bildung eines Netzwerkbildners, z.B. aus in der Schmelze enthaltenen Zwischenoxiden Bismutoxid und Kupferoxid, unterstützt, wird der Vorteil erzielt, daß die Teile der Schmelze, die zur Entmischung neigen, ineinander löslich werden. Dadurch wird eine Entmischung verhindert. Das bedeutet, daß eine sogenannte Mischungslücke beseitigt wird. Eine nicht entmischte, homogene Schmelze oder ein daraus erstarrtes homogenes Glas ist die Voraussetzung für die Bildung eines qualitativ hochwertigen hochtemperatursupraleitenden Stoffes.

Ein weiterer Vorteil beim Herstellen des hochtemperatursupra leitenden Stoffes nach der Erfindung, wobei ein Auskristallisieren aus einer Schmelze erfolgt, ist darin zu sehen, daß durch die Zusatzoxide die Viskosität der Schmelze beeinflußt wird. Dadurch verzögert sich das Auskristallisieren unerwünschter Stoffe so lange, bis durch Abkühlen die Kristallisationstemperatur des hochtemperatursupraleitenden Stoffes erreicht ist. Die die Hochtemperatursupraleitung behindernden Stoffe gelangen also nicht in den auskristallisierten Körper.

Falls die Schmelze zu einem Glas erstarrt wird, das dann zu einer Fritte gemahlen wird, die dann als Glaskeramik-Email auf den Trägerkörper aufgebracht wird, wird mit einem Verfahren nach der Erfindung der Vorteil erzielt, daß Kristallisationsvorgänge in der Fritte beim Erwärmen während des Emaillierens generell verlangsamt sind.

Dadurch verzögert sich das Auskristallisieren unerwünschter Stoffe so lange, bis durch Erwärmen der Fritte die Kristallisationstemperatur des hochtemperatursupraleitenden Stoffes erreicht ist. Die die Hochtemperatursupraleitung behindern den Stoffe gelangen also auch beim Emaillierverfahren, bei dem die Kristallisationstemperatur des hochtemperatursupraleitenden Stoffes durch Erwärmen von einem niedrigen Niveau aus eingestellt wird, nicht in den auskristallisierten Körper.

Mit dem Verfahren nach der Erfindung wird der Vorteil erzielt, daß mit der Schmelze, die aus geeigneten Oxiden, wie Y-Ba-Cu-Oxid, gebildet ist, ein hochtemperatursupraleitendes Bauteil mit homogenen Eigenschaften hergestellt werden kann. Ein solches Bauteil hat über seine räumliche Erstreckung bei Kühlung, z.B. mit flüssigem Stickstoff, eine gleichbleibende hohe elektrische Leitfähigkeit.

Der Schmelze wird beispielsweise ein Zusatzoxid zugemischt, dessen Dietzelsche Feldstärke größer als 0,4 und kleiner als 1,0 ist. Mit einem solchen Zusatzoxid, das als Netzwerkbildner wirkt, oder die Bildung eines Netzwerkbildners unterstützt, wird ein Entmischen der Schmelze oder beim Emaillierverfahren ein Entmischen des Glases bzw. der Fritte verhindert und das Auskristallisieren von störenden Stoffen um eine so große Zeitspanne verzögert, daß für das Auskristallisieren der Schmelze bzw. des Glases (Fritte) ein ausreichend großer Zeitraum zur Verfügung steht.

Beispielsweise wird der Schmelze ein Carbonat oder Nitrat zugemischt, das sich zu Zusatzoxid zersetzt. Diese Chemikalien sind oft kostengünstiger erhältlich als die benötigten Zusatzoxide selbst.

Als Zusatzoxid sind beispielsweise folgende Oxide besonders geeignet: $B_2O_3$, $SiO_2$, $GeO_2$, $Ta_2O_5$, $Sb_2O_3$, $Nb_2O_5$, $As_2O_3$, $Al_2O_3$, $Y_2O_3$ oder $Ga_2O_3$. Diese Oxide können einzeln oder als Mischung zugemischt werden. Die Mischung kann aus allen genannten Oxiden oder nur aus einem Teil der Oxide bestehen. Auch kann die Mischung weitere nicht genannte Stoffe enthalten.

Die genannten Zusatzoxide sind besonders geeignet, eine Entmischung der Schmelze zu verhindern und ein Auskristallisieren von störenden Bestandteilen sowohl in der Schmelze als auch in einer eingefrorenen, unterkühlten Schmelze, dem Glas, sowie in der aus dem Glas gebildeten Fritte, zu verzögern.

Der Schmelze werden beispielsweise 0,5 Gewichtsprozent bis 10 Gewichtsprozent Zusatzoxid zugemischt. Dabei ist die Einwaage der die Supraleitung bewirkenden Bestandteile in die Schmelze 100 Gewichtsprozent gleichgesetzt. Insbesondere werden ein Gewichtsprozent bis 3 Gewichtsprozent Zusatzoxid der Schmelze zugemischt.

Dadurch, daß im Vergleich zur Menge der Bestandteile der Schmelze, die die Supraleitung bewirken, nur wenig Zusatzoxid zugemischt wird, wird der Vorteil erzielt, daß die Zusammensetzung der Schmelze durch das Zusatzoxid nur wenig verfälscht wird. Die geringe Zumischung von Zusatzoxid reicht aber aus, um ein Entmischen der Schmelze zu verhindern. Die stoffliche Zusammensetzung des späteren Supraleiters wird durch das Zusatzoxid nicht merkbar verändert. Der qualitativen Verbesserung des Supraleiters durch die Zumischung von Zusatzoxid in die Schmelze steht also keine Verschlechterung des Supraleiters gegenüber.

Beispielsweise werden der Schmelze 0,5 Gewichtsprozent $SiO_2$ zugemischt. Nach einem anderen Beispiel wird der Schmelze 1 Gewichtsprozent $B_2O_3$ zugemischt. Nach einem weiteren Beispiel werden der Schmelze 3 Gewichtsprozent $GeO_2$ zugemischt. Diese Oxide zeigen besonders günstige Ergebnisse beim Verhindern einer Entmischung der Schmelze oder des Glases (der Fritte) und beim Verzögern des Auskristallisierens von Fremdstoffen aus der Schmelze oder aus dem Glas (der Fritte).

Mit "Schmelze" wird eine flüssige Oxidschmelze aber auch eine erstarrte und gemahlene Schmelze, die pulverförmige sogenannte Fritte, bezeichnet.

Die als zweite genannte Aufgabe, die vorsieht, ein hochtemperatursupraleitendes Bauteil anzugeben, das vorzugsweise mit dem Verfahren nach der Erfindung hergestellt ist, und das aus einer Oxide, insbesondere Bi-Sr-Ca-Cu-Oxid oder Y-Ba-Cu-Oxid oder Seltene Erde-Ba-Cu-Oxid oder Tl-Sr-Ca-Cu-Oxid, enthaltenden Schmelze gebildet ist, die auf einen Trägerkörper aufgebracht ist, wird gemäß der Erfindung dadurch gelöst, daß der Schmelze oder einer aus der Schmelze gebildeten Fritte ein Zusatzoxid mit einer Dietzelschen Feldstärke, die größer als 0,4 ist, zugemischt ist.

Ein derartiges hochtemperatursupraleitendes Bauteil weist eine durchgehend homogene supraleitende Zone auf. Es sind keine Inhomogenitäten vorhanden, die auf den Ablauf der Kristallisation der Schmelze zurückzuführen wären.

Mit dem Verfahren zum Herstellen eines hochtemperatursuprallei tenden Bauteiles nach der Erfindung und mit dem Bauteil wird der Vorteil erzielt, daß bei entsprechender Kühlung des Bauteiles über die gesamte hochtemperatursupraleitende Zone des Bauteiles ein gleichbleibend verschwindender Widerstand gewährleistet ist.

## Ansprüche

1. Verfahren zum Herstellen eine hochtemperatursupraleitenden Bauteiles, wobei aus Oxiden, insbesondere aus Bi-Sr-Ca-Cu-Oxid oder Y-Ba-Cu-Oxid oder Seltene Erde-Ba-Cu-oxid oder Tl-Sr-Ca-Cu-Oxid eine Schmelze gebildet wird, welche anschließend auf einen Trägerkörper aufgebracht wird und dort bei einer Kristallisationstemperatur auskristallisiert wird,
**dadurch gekennzeichnet,** daß der Schmelze ein Zusatzoxid mit einer Dietzelschen Feldstärke, die größer als 0,4 ist, zugemischt wird.

2. Verfahren zum Herstellen eines hochtemperatursupraleitenden Bauteiles, wobei aus Oxiden, insbesondere aus Bi-Sr-Ca-Cu-Oxid oder Y-Ba-Cu-Oxid oder Seltene Erde-Ba-Cu-Oxid oder Tl-Sr-Ca-Cu-Oxid eine Schmelze gebildet wird, die zu einem Glas erstarrt wird, das zu einer Fritte gemahlen wird, die dann als Glaskeramik-Email auf einen Trägerkörper aufgebracht wird,
**dadurch gekennzeichnet,** daß der erstarrten, gemahlenen Schmelze, der Fritte, ein Zusatzoxid mit einer Dietzelschen Feldstärke, die größer als 0,4 ist, in Pulverform zugemischt wird.

3. Verfahren nach einem der Ansprüche 1 oder 2,
**dadurch gekennzeichnet,** daß der Schmelze ein Zusatzoxid zugemischt wird, dessen Dietzelsche Feldstärke größer als 0,4 und kleiner als 1,0 ist.

4. Verfahren nach einem der Ansprüche 1 bis 3,
**dadurch gekennzeichnet,** daß der Schmelze ein Carbonat oder Nitrat zugemischt wird, das sich zu Zusatzoxid zersetzt.

5. Verfahren nach einem der Ansprüche 1 bis 3,
**dadurch gekennzeichnet,** daß der Schmelze $B_2O_3$ oder $SiO_2$ oder $GeO_2$ oder $Ta_2O_5$ oder $Sb_2O_3$ oder $Nb_2O_5$ oder $As_2O_3$ oder $Al_2O_3$ oder $Y_2O_3$ oder $Ga_2O_3$ zugemischt wird.

6. Verfahren nach einem der Ansprüche 1 bis 5,
**dadurch gekennzeichnet,** daß der Schmelze 0,5 Gewichtsprozent bis 10 Gewichtsprozent Zusatzoxid zugemischt werden, wobei die Einwaage der die Supraleitung bewirkenden Bestandteile der Schmelze 100 Gewichtsprozent sind.

7. Verfahren nach Anspruch 6, **dadurch gekennzeichnet,** dar der Schmelze ein Gewichtsprozent bis drei Gewichtsprozent Zusatzoxid zugemischt werden.

8. Verfahren nach einem der Ansprüche 5 bis 7,
**dadurch gekennzeichnet,** daß der Schmelze 0,5 Gewichtsprozent $SiO_2$ zugemischt werden.

9. Verfahren nach einem der Ansprüche 5 bis 8,
**dadurch gekennzeichnet,** daß der Schmelze 1,0 Gewichtsprozent $B_2O_3$ zugemischt wird.

10. Verfahren nach einem der Ansprüche 5 bis 9,
**dadurch gekennzeichnet,** daß der Schmelze 3,0 Gewichtsprozent $GeO_2$ zugemischt werden.

11. Hochtemperatursupraleitendes Bauteil, gebildet aus einer Schmelze, die Oxide, insbesondere Bi-Sr-Ca-Cu-Oxid oder Y-Ba-Cu-Oxid oder Seltene Erde-Ba-Cu-Oxid oder Tl-Sr-Ca-Cu-Oxid enthält, und die auf einen Trägerkörper aufgebracht ist, hergestellt mit einem Verfahren vorzugsweise nach einem der Ansprüche 1 bis 10,

**dadurch gekennzeichnet,**

daß der Schmelze oder einer aus der Schmelze gebildeten Fritte ein Zusatzoxid mit einer Dietzelschen Feldstärke, die größer als 0,4 ist, zugemischt ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | BRITISH CERAMIC PROCEEDINGS, no. 40, March 1988, pages 161-173, London, UK; Newcomb, S.B. et al: "Microstructure, critical currents and flux pinning in Y-Ba-Cu-O superconductors" * Page 162, paragraph 5; page 172, paragraphs 2-3 * --- | 1-3,6-8 ,11 | H 01 L 39/24 |
| X | JOURNAL OF MATERIALS SCIENCE LETTERS, vol. 8, no. 1, January 1989, pages 19-20, New York, US; Suzuki, T. et al: "Superconducting transition temperature in the (YBa2Cu3Oy)1-x(MeO)x system (MeO=AlO1.5, CeO2, CrO1.5, GaO1.5, GeO2, InO1.5, MgO, MnO2, NbO2.5, TiO2 and ZrO2)" * Page 19, full page * ----- | 1-3,6-8 ,10-11 | |

**RECHERCHIERTE SACHGEBIETE (Int. Cl.5)**

H 01 L 39

Der vorliegende Recherchenbericht wurde für alle Patentansprüche erstellt

| Recherchenort | Abschlußdatum der Recherche | Prüfer |
|---|---|---|
| DEN HAAG | 05-02-1990 | HAMMEL E.J. |